# EUROPÄISCHE PATENTSCHRIFT

(11) **EP 0 737 317 B1**
(45) Veröffentlichungstag und Bekanntmachung des Hinweises auf die Patenterteilung: **08.04.1998**
(21) Anmeldenummer: 95901322.8
(22) Anmeldetag: 23.11.1994
(51) Int. Cl.: G01R 25/08, G01R 25/04, H03L 7/085

(54) **DIGITALER PHASENDETEKTOR**
DIGITAL PHASE DETECTOR
DETECTEUR DE PHASE NUMERIQUE

(30) Priorität: 29.12.1993 DE 4344867
(43) Veröffentlichungstag der Anmeldung: 16.10.1996
(73) Patentinhaber: ROBERT BOSCH GMBH, 70442 Stuttgart (DE)
(72) Erfinder: MELLER, Wolfgang, D-71522 Backnang (DE); WIDMANN, Fritz, D-74360 Ilsfeld (DE)
(86) Internationale Anmeldenummer: DE9401380
(87) Internationale Veröffentlichungsnummer: WO9518384

(56) Entgegenhaltungen:
- FR-A- 2 406 848
- GB-A- 2 075 294
- US-A- 3 913 028
- ELECTRONICS. DE 1984 A 1985 : ELECTRONICS WEEK, Bd.54, Nr.19, September 1981, NEW YORK US Seiten 156 - 157 ABDEL-AAL 'DIGITAL PHASE METER UPDATES MEASUREMENT EACH CYCLE'

## Beschreibung

Die vorliegende Erfindung betrifft einen digitalen Phasendetektor mit den Merkmalen des Oberbegriffs des Anspruchs 1.

Aus N. Nessler, D. Fritz: "Ein digitales Phasenmeßgerät", ELEKTRONIK 1974, Heft 9, Band 23, Seite 319 ff ist ein Phasenmeßgerät bekannt, das einen digitalen Phasendetektor der eingangs genannten Art enthält.

Ein digitaler Phasendetektor mit Mitteln, die aus zeitlich aufeinanderfolgenden Impulsen eines Referenztaktes und eines Vergleichstakts Start- und Stopsignale generieren und mit einem Zähler, der Impulse eines Zähltaktes in dem Zeitfenster zwischen einem Startsignal und dem nachfolgenden Stopsignal hochzählt, wobei der Zählerwert des Zählers ein Maß für die Phasenverschiebung zwischen dem Referenztakt und den Vergleichstakt darstellt, ist aus R. Best: "Theorie und Anwendungen des Phase-looked Loops", AT-Verlag Aarau, Stuttgart, 4. Auflage, 1987, S. 46, Bild 31/3, bekannt. Dieser Phasendetektor besitzt den Nachteil, daß sehr kleine Phasenabweichungen aufgrund von Quantisierungsfehlern nicht erkannt werden.

Ein analoger Phasendetektor, der ein mit einem Vorzeichen behaftetes Ausgangssignal liefert, ist in Tietze/Schenk: "Halbleiter-Schaltungstechnik", Springer-Verlag Berlin, Heidelberg, 10. Auflage, 1993, S. 962ff. offenbart. Dieses Ausgangssignal ist ein Rechteckimpuls, dessen Breite proportional zu der Phasendifferenz und dessen Amplitude bei negativer Phasendifferenz negativ ist.

Der Erfindung liegt die Aufgabe zugrunde, einen aufwandsarmen digitalen Phasendetektor der eingangs genannten Art anzugeben, der eine hohe Phasenauflösung aufweist.

Diese Aufgabe wird erfindungsgemäß durch die Merkmale des Anspruchs 1 gelöst. Weitere vorteilhafte Ausführungsformen gehen aus den Unteransprüchen hervor.

Ein digitaler Phasendetektor, der eine Phasendifferenz zwischen zwei Impulsen bestimmt, indem er die zwischen den Impulsen bestehende Zeitdifferenz mittels eines höherfrequenten Zähltaktes auszählt, weist Quantisierungsfehler auf. Auch bei einem sehr hohen Zähltakt ist die Genauigkeit dieses Phasendetektors oft nicht zufriedenstellend. Durch die Maßnahmen der Erfindung werden die Auswirkungen des Quantisierungsfehlers auf die Ausgangsphase eines Phasenregelkreises erheblich reduziert. Ein Vergleichstakt kann präzise einem Referenztakt nachgeführt werden.

Ausführungsbeispiele der Erfindung werden anhand der Zeichnungen erläutert. Es zeigen:
Figur 1 einen digitalen Phasendetektor,
Figur 2 die zeitlichen Signalabläufe im Phasendetektor nach der Figur 1,
Figur 3 eine Detektorkennlinie eines digitalen
Phasendetektors ohne Vorzeicheninformation,
Figur 4 eine Detektorkennlinie eines digitalen
Phasendetektors mit einer Vorzeicheninformation,
Figur 5 eine Detektorkennlinie eines digitalen Phasendetektors, die im Nullpunkt einen Sprung enthält,
Figur 6 eine Phasenregelschleife mit einem digitalen Phasendetektor, bei dem die Verarbeitung des Vorzeichens und die Erzeugung des Sprungs im Nullpunkt der Detektorkennlinie in einem Speicher abgespeichert ist, und
Figur 7 eine Phasenregelschleife mit einem digitalen Phasendetektor, bei dem die Verarbeitung des Vorzeichens und die Erzeugung des Sprungs im Nullpunkt der Detektorkennlinie schaltungstechnisch realisiert ist.

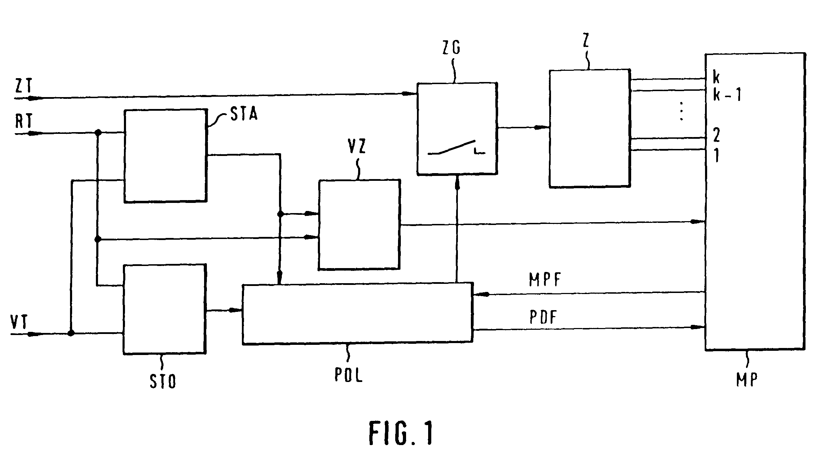

In der Figur 1 ist ein digitaler Phasendetektor dargestellt, der Phasendifferenzen zwischen Impulsen eines Referenztakts RT und eines Vergleichstakts VT bestimmt. Der Referenztakt RT und der Vergleichstakt VT liegen beide an einem logischen Gatter STA, das Startsignale erzeugt, und an einem logischen Gatter STO, das Stopsignale erzeugt, an. Für diese ersten Mittel STA und STO können auch andere Bauteile verwendet werden. Ein erster Impuls erzeugt ein Startsignal, und ein dem ersten nachfolgender zweiter Impuls erzeugt das zugehörige Stopsignal, unabhängig davon, welcher der beiden Impulse vom Referenztakt RT und vom Vergleichstakt VT stammt. Zweite Mittel, z.B. ein logisches Gatter VZ, erkennen, welcher der beiden Takte, Referenztakt RT oder Vergleichstakt VT, das jeweilige Startsignal ausgelöst hat. Das Gatter VZ liefert also die Information, ob die Phase des Vergleichstakts VT in Bezug auf den Referenztakt RT voreilend oder nacheilend ist. Dies ist gleichbedeutend mit einer Vorzeicheninformation.

Um eine gute Zeitauflösung zu erreichen, ist es vorteilhaft, für den Referenztakt RT und den Vergleichstakt VT Rechtecksignale und für die logischen Gatter STA und STO Gatter, die auf die Flanken dieser Rechtecksignale triggern, zu verwenden.

Eine logische Schaltung PDL steuert mit Hilfe der Start- und Stopsignale ein Zählertor ZG. Mit diesem und einem Zähler Z werden Impulse eines Zähltaktes ZT hochgezählt. Das Ergebnis wird an einer parallelen Schnittstelle 1, 2, ..., k des Zählers Z ausgegeben. Die Phasendifferenz zwischen den Impulsen des Referenztakts RT und des Vergleichstakts VT liegt also digital als Zählerwert vor und kann vorteilhafterweise direkt von beispielsweise einer Recheneinheit MP verarbeitet werden. Um einen kleinen Quantisierungsfehler, der durch die digitale Auflösung entsteht, zu erhalten, muß die Frequenz des Zähltaktes ZT möglichst hoch sein.

Dritte Mittel, z.B. eine Recheneinheit MP, die ein Mikroprozessor, Signalprozessor oder ASIC sein kann, bewirken die Steuerung und Informationsverarbeitung des Phasendetektors. Ist ein Zählerwert in die Recheneinheit MP eingelesen, so gibt diese an die logische Schaltung PDL ein Signal MPF ab. Diese setzt daraufhin den Zähler Z und das Gatter VZ zurück und startet einen neuen Zählzyklus im Zählertor ZG und Zähler Z mittels eines Start- und Stopimpulses. Ist der Zählzyklus beendet und liegt der Zählerwert an der parallelen Schnittstelle des Zählers Z an, so sendet die logische Schaltung PDL ein Signal PDF an die Recheneinheit MP, damit diese den Zählerwert und die Vorzeicheninformation einliest. Auf diese Weise wird in periodischen Abständen, mit der Periode des Referenztakts RT, die Phasendifferenz zwischen Impulsen des Referenztakts RT und des Vergleichstakts VT bestimmt.

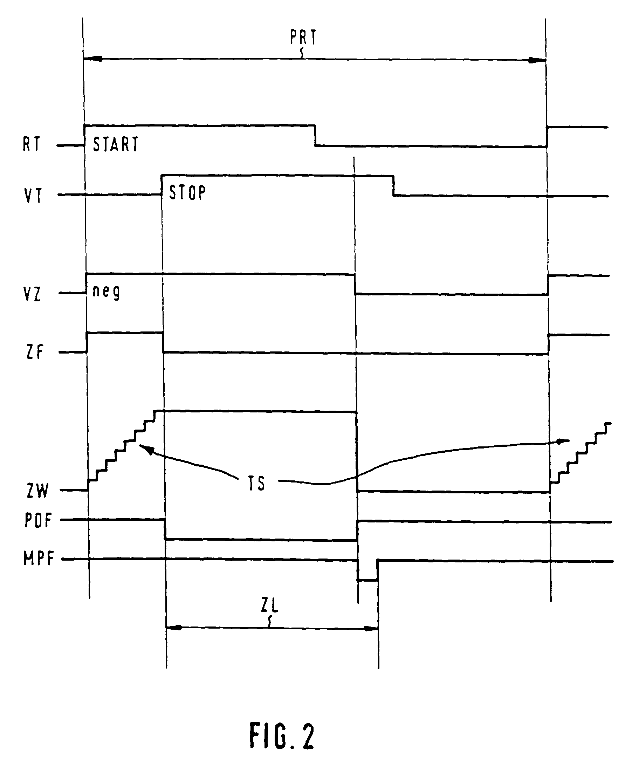

Der zeitliche Ablauf der Signale des digitalen Phasendetektors ist in der Figur 2 dargestellt. RT bezeichnet den Referenztakt RT, der eine Periodendauer PRT aufweist, und VT den Vergleichstakt VT. Die Phase des Referenztakts RT ist gegenüber der Phase des Vergleichstakts VT voreilend und erzeugt daher ein Startsignal (in dem logischen Gatter STA, Fig. 1). Der Impuls des Vergleichstakts VT erzeugt ein Stopsignal. Die Information, daß der Impuls des Referenztakts RT dem Impuls des Vergleichstakts VT voreilt, kann als Vorzeicheninformation VZ interpretiert werden und ist in diesem Ausführungsbeispiel mit negativ neg bezeichnet.

Das Startsignal und das Stopsignal definieren ein Zeitfenster ZF, in dem das Zählertor ZG und der Zähler Z (Fig. 1) die Impulse des Zeittaktes ZT hochzählen. Das Ergebnis ist der Zählerwert ZW. Die Hochzählphase des Zählerwerts ZW ist in der Figur 2 in Form von Treppenstufen TS dargestellt.

Das hier vom Vergleichstakt VT stammende Stopsignal erzeugt in der logischen Schaltung PDL (Fig. 1) das Signal PDF, das die Recheneinheit MP veranlaßt, den Zählerwert ZW einzulesen. Ist die Recheneinheit MP mit dem Einlesen des Zählerwerts ZW und der Informationsverarbeitung fertig, so gibt sie das Signal MPF an die logische Schaltung PDL ab. Das Signal MPF veranlaßt die logische Schaltung PDL, den Zählerwert ZW und die Vorzeicheninformation VZ zurückzusetzen. Nach der Zeitdauer ZL ist die Recheneinheit MP bereit für einen neuen Zählzyklus.

Der in der Figur 2 dargestellte zeitliche Ablauf der Signale ist beispielhaft. So können beispielsweise die Signale PDF und MPF auch zu späteren Zeitpunkten erfolgen.

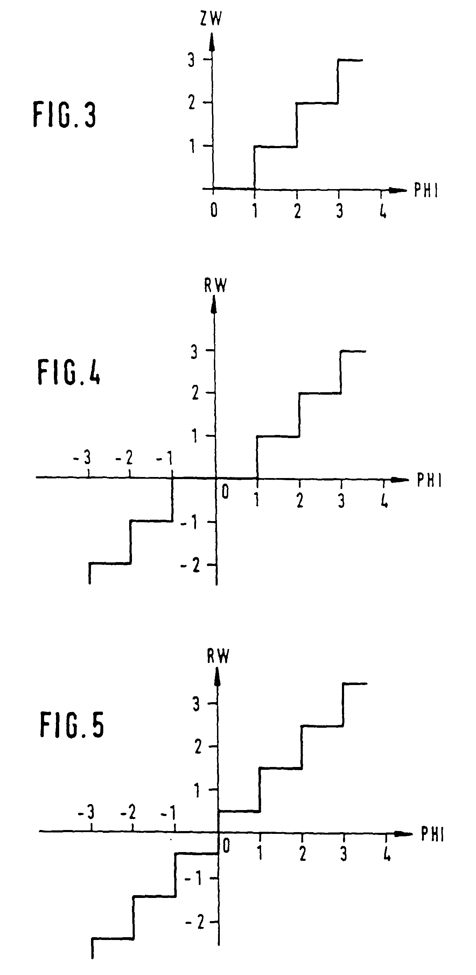

Der Zählerwert ZW steht in Bezug zu einer quantisierten Phasendifferenz PHI, wie in dem Diagramm der Figur 3 dargestellt.

In dem Diagramm der Figur 4 ist die Vorzeicheninformation VZ zu einem Rechenwert RW mit eingerechnet, so daß auch negative Phasendifferenzen PHI definiert sind. Dies kann in der Recheneinheit MP (Fig. 1) z.B. durch Multiplikation des Zählerwerts ZW mit der Vorzeicheninformation VZ realisiert werden.

Der Rechenwert RW als Funktion der Phasendifferenz PHI stellt eine Kennlinie des Phasendetektors dar. Der Funktion in der Figur 4 ist zu entnehmen, daß dem Rechenwert RW = 0 ein Phasenbereich PHI von -1 bis +1 zugeordnet ist.

In dem Diagramm der Figur 5 ist eine Kennlinie eines digitalen Phasendetektors dargestellt, die an der Stelle PHI = 0 einen Sprung aufweist. Ein Phasendetektor mit dieser Kennlinie läßt sich vorteilhaft in einem Phasenregelkreis einsetzen, um die Auswirkungen der Quantisierungsstufen des digitalen Phasendetektors auf den Vergleichstakt VT erheblich zu reduzieren. Durch den Sprung an der Stelle PHI = 0 wird das Phasenrauschen (hervorgerufen durch die Quantisierung) des digitalen Phasendetektors wesentlich verringert, da auch bei kleinsten Phasendifferenzen PHI ein Rechenwert RW größer oder kleiner Null vorhanden ist. Die Vorzeicheninformation VZ sagt aus, ob die Phase des Vergleichstakts VT der des Referenztakts RT vor- oder nacheilt. Dies bildet für den Phasenregelkreis auch bei sehr kleinen Phasendifferenzen PHI eine Information, ob die Frequenz des Vergleichstakts erhöht oder erniedrigt werden muß. Durch diese Maßnahme wird eine sehr gute Phasensynchronisation erreicht.

Die Kennlinie der Figur 5 kann aus der Kennlinie der Figur 3 abgeleitet werden, indem zu dieser erst ein Zahlenwert, z.B. 0,5, hinzuaddiert wird und das so erhaltene Resultat anschließend mit dem Vorzeichen multipliziert wird. Die Kennlinie der Figur 5, die durch den Nullpunkt geht, kann auch aus diesem verschoben sein. Dies ermöglicht beispielsweise einen Phasenregelkreis, der einen Vergleichstakt auf eine Phasenverschiebung ungleich Null, in Bezug auf einen Referenztakt RT, einregelt. Hierfür wird von dem Zählerwert ZW zuerst eine Konstante, die dieser Phasenverschiebung entspricht, subtrahiert, anschließend wird 0,5 hinzuaddiert und dann mit dem Vorzeichen multipliziert.

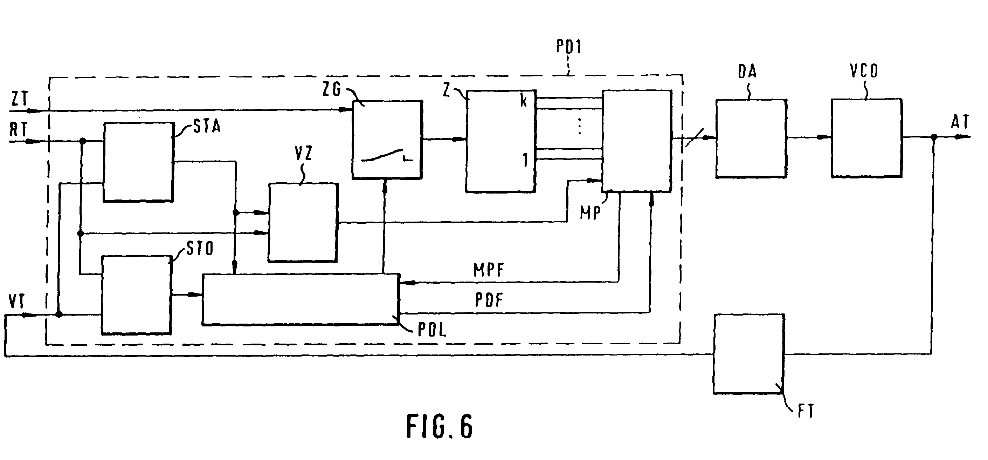

In der Figur 6 ist ein Phasenregelkreis mit einem digitalen Phasendetektor PD1, einem Digital-Analog-Wandler DA, einem abstimmbaren Oszillator VCO und einem Frequenzteiler FT dargestellt. Der Frequenzteiler FT bewirkt einen von der Frequenz des Referenztaktes RT verschiedenen Ausgangs takt AT.

Der Phasendetektor PD1 entspricht dem des anhand der Figur 1 beschriebenen Phasendetektors. Eine Recheneinheit MP registriert in periodischen Abständen einen Zählerwert des Zählers Z und eine Vorzeicheninformation des logischen Gatters VZ. Diese Daten verarbeitet die Recheneinheit MP intern mittels eines Programmablaufs, um die Detektorkennlinie nach Figur 5 zu erzeugen. Basierend auf der Detektorkennlinie steuert die Recheneinheit MP den Oszillator VCO, um den Vergleichstakt VT nachzuregeln.

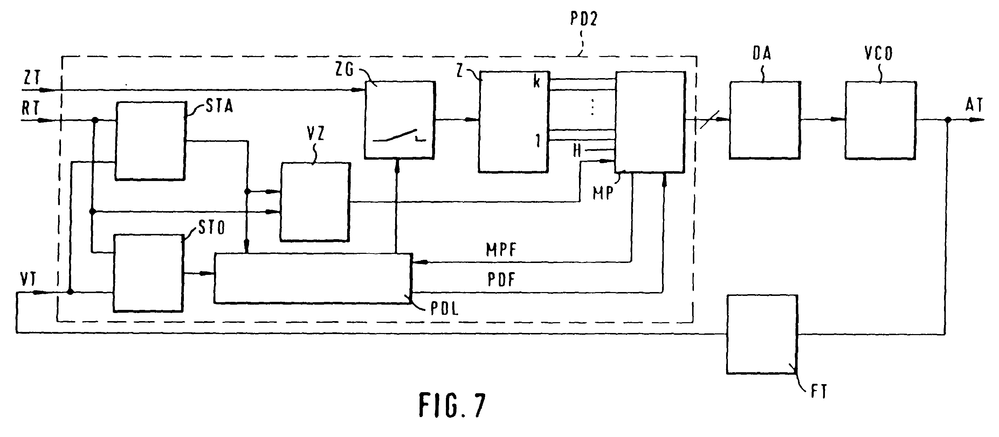

In der Figur 7 ist ein Phasenregelkreis mit einem weiteren digitalen Phasendetektor PD2 dargestellt. Der Zählerwert des Zählers Z und die Vorzeicheninformation des logischen Gatters VZ sind hier in der Weise mit der Recheneinheit MP schaltungstechnisch verbunden, daß der Rechenaufwand in der Recheneinheit MP zur Erzeugung der Detektorkennlinie entfällt. Hierzu werden die k Bits 1, 2, ... k des Zählerwerts am Eingang der Recheneinheit MP an den Stellen 2, 3, ... k+1 eingelesen und die Eingangsleitung für das niedrigste Bit 1 fest auf Pegel H (hoch) gelegt. Dies entspricht im dualen System einer Addition des Zählerwerts mit 0,5. Die Vorzeicheninformation Vt ist mit dem für das Vorzeichen zuständigen Eingangsbit des Dateneingangs verbunden.

## Patentansprüche

1. Digitaler Phasendetektor zur Gewinnung von Phaseninformationen zwischen einem Referenztakt und einem Vergleichstakt, mit ersten Mitteln (STA, STO), die aus zeitlich aufeinanderfolgenden Impulsen des Referenz- und Vergleichstakts Start- und Stopsignale generieren, mit einem Zähler (Z), der Impulse eines Zähltakts in dem Zeitfenster zwischen einem Startsignal und dem nachfolgenden Stopsignal hochzählt, wobei der Zählerwert des Zählers (Z) ein Maß für die Phasenverschiebung zwischen dem Referenztakt und dem Vergleichstakt darstellt, und mit zweiten Mitteln (VZ), die aus dem im Vergleich zum Referenztakt vor- oder nacheilenden Vergleichstakt eine Vorzeicheninformation gewinnen, dadurch gekennzeichnet, daß dritte Mittel (MP) vorhanden sind, die zu dem Zählerwert (ZW) eine Konstante hinzuaddieren und dem resultierenden Wert die Vorzeicheninformation zuordnen.

2. Digitaler Phasendetektor nach Anspruch 1, dadurch gekennzeichnet, daß zur Durchführung der Addition der Konstanten eine feste Beschaltung am Dateneingang der dritten Mittel (MP) vorgesehen ist.

3. Digitaler Phasendetektor nach Anspruch 1 oder 2, dadurch gekennzeichnet, daß die dritten Mittel (MP) zu dem Zählerwert eine Konstante 0,5 hinzuaddieren, indem die k Bits des Zählerwerts am Eingang der dritten Mittel (MP) um 1 Bit in Richtung des höheren Bits verschoben werden und das niedrigste Bit dieses Eingangs permanent auf Pegel "H" gelegt wird.

4. Digitaler Phasendetektor nach einem der vorhergehenden Ansprüche, dadurch gekennzeichnet, daß er in einem Phasenregelkreis eingesetzt ist.

## Claims

1. Digital phase detector for obtaining information relating to the phase between a reference clock and a comparison clock, having first means (STA, STO) which generate start and stop signals from temporally successive pulses of the reference and comparison clocks, having a counter (Z) which counts up the pulses of a count clock in the time window between a start signal and the following stop signal, the count of the counter (Z) representing a measure of the phase shift between the reference clock and the comparison clock, and having second means (VZ) which obtain sign information from the comparison clock which leads or lags relative to the reference clock, characterized in that there are third means (MP) which add a constant to the count (ZW) and assign the sign information to the resulting value.

2. Digital phase detector according to Claim 1, characterized in that fixed circuitry is provided at the data input of the third means (MP), in order to carry out the addition of the constants.

3. Digital phase detector according to Claim 1 or 2, characterized in that the third means (MP) add a constant of 0.5 to the count, by the k bits of the count at the input of the third means (MP) being shifted by one bit in the direction of the most significant bit, and the least significant bit of this input being set permanently to the level "H".

4. Digital phase detector according to one of the preceding claims, characterized in that it is used in a phase-locked loop.

## Revendications

1. Détecteur de phase numérique pour obtenir des informations de phase, entre une cadence de référence et une cadence de comparaison, comprenant :
- des premiers moyens (STA, STO) qui génèrent des signaux de départ et d'arrêt à partir d'impulsions de référence et de la cadence de comparaison,
- un compteur (Z) qui compte les impulsions d'une cadence de comptage dans la fenêtre de temps comprise entre un signal de départ et le signal d'arrêt suivant, la valeur de comptage du compteur (7) étant une mesure du déphasage entre la cadence de référence et la cadence de comparaison,
- ainsi que des seconds moyens (VZ) qui donnent une information de signe algébrique à partir de la comparaison entre la cadence de référence et la cadence de comparaison en amont ou en aval,
caractérisé par
des troisièmes moyens (MP) qui ajoutent une constante à la valeur de comptage (ZW) et attribuent l'information de signe algébrique à la valeur résultante.

2. Détecteur de phase numérique selon la revendication 1,
caractérisé par
un circuit fixe prévu à l'entrée de données des troisièmes moyens (MP) pour effectuer l'addition des constantes.

3. Détecteur de phase numérique selon la revendication 1 ou 2,
caractérisé en ce que
- les troisièmes moyens (MP) ajoutent une constante 0,5, à l'état de comptage, en décalant les k bits de l'état de comptage à l'entrée du troisième moyen (MP), de 1 bit en direction des bits supérieurs, et
- le bit le plus faible de cette entrée est mis en permanence au niveau « H ».

4. Détecteur de phase numérique selon une quelconque des revendications précédentes,
caractérisé en ce qu'
il est monté dans un circuit de régulation de phase.
